# EUROPEAN PATENT SPECIFICATION

(11) **EP 1 383 690 B1**
(45) Date of publication and mention of the grant of the patent: **21.06.2006**
(21) Application number: 02766715.3
(22) Date of filing: 26.04.2002
(51) Int. Cl.: B65D 65/38, B32B 29/00, D21F 11/12, D21H 27/12, H05K 9/00

(54) **A PACKAGING UNIT FOR PROTECTING ELECTRONIC COMPONENTS FROM ELECTROSTATIC DISCHARGE, PAPER FOR A PACKING UNIT AND A METHOD OF MANUFACTURING SAID PAPER**
VERPACKUNGSEINHEIT ZUM SCHUTZ VON ELEKTRONISCHEN BAUTEILEN GEGEN ELEKTROSTATISCHE ENTLADUNG, PAPIER FÜR EINE VERPACKUNGSEINHEIT UND VERFAHREN ZUR HERSTELLUNG DES PAPIERS
EMBALLAGE DESTINE A PROTEGER DES COMPOSANTS ELECTRONIQUES DE DECHARGES ELECTROSTATIQUES, PAPIER POUR CET EMBALLAGE ET PROCEDE DE FABRICATION DE CE PAPIER

(30) Priority: 30.04.2001 SE 0101528
(43) Date of publication of application: 28.01.2004
(73) Proprietor: Smurfit Munksjö Packaging AB, 382 28 Nybro (SE)
(72) Inventor: ULFHEIM, Lars-Anders, S-388 96 Ljungbyholm (SE); THORÉN, Stefan, S-554 66 Jönköping (SE)
(74) Representative: Nyberg, Bengt
(86) International application number: PCT/SE2002/000823
(87) International publication number: WO 2002/087989

(56) References cited:
- EP-A1- 0 508 044
- WO-A1-99/29503
- US-A- 3 048 515
- US-A- 4 606 790
- US-A- 4 684 020
- US-A- 4 883 172
- US-A- 5 354 950
- US-A- 5 407 714
- US-A- 5 637 377

## Description

### Field of the invention

The present invention relates to a packaging unit, and more particularly to a packaging unit for protecting electronic components against electrostatic discharge. The packaging unit is formed of a cardboard material, which is made of several layers of paper. The invention also relates to a paper incorporated in such a packaging unit and a method for producing such a paper in a paper manufacturing machine.

### Background of the invention

Static electricity is generated through an electrostatic discharge from one surface to another, the transferred charge being held on the new carrier. It is a well known fact that static electricity causes significant problems in the electronics industry and in handling and distribution of electronic components. The time of duration for an electrostatic discharge is very short, such as a microsecond or shorter, and the electronic systems comprise components which are very sensitive to such electrostatic discharge. It is thus very important to observe strict rules and standards in order to protect components and systems against static electricity in the manufacturing, handling and distribution of the components and systems. Consequently, a comprehensive protective work has been carried out in order to reduce the damages, particularly in the electronics industry, and several rules, specifications and standards have been set in order to control and systemise the protective work.

It is further important that this type of sensitive components and goods are protected against electrostatic discharge during distribution, handling and storing. For this purpose, a variety of types of and materials for packaging units adapted for protecting components against electrostatic discharge have been developed and tested. In general, the more conductive and efficiently enclosing a material is, the better is the shielding effect against electrostatic fields. Packaging materials of paper or cardboard are naturally hygroscopic and thus have a certain conductivity. Although ordinary boxes of corrugated cardboard are antistatic or electrostatic dissipative at high relative humidity, the cardboard in the boxes is not sufficiently conductive to provide the required electrostatic shielding. In addition, when the relative humidity decreases, the conductivity of the untreated cardboard is reduced such that the protection against electrostatic discharge will be insufficient.

As described inter alia in US 4,211,324, this problem has been solved by applying a conductive coating with carbon black particles (Carbon Black) on the paperboard surface. Materials with carbon content are low resistive and may thus not be charged up to high values. Carbonaceous substances have thus been used to coat a surface layer on the cardboard packaging units in order to protect the packaged electronic components from electrostatic discharge. However, when the box or packaging unit is erected or handled, conductive carbon particles tend to slough off from the surface and may form bridges in the printed circuit cards and components. This may cause serious problems and short-circuit.

A solution to this problem has been proposed in US 4,482,048, the disclosure of which proposes a coating of the interior surface of an outer liner of a corrugated board with an electrostatic shielding layer, which is not exposed to wear and rubbing in the same manner as an exterior layer. This solution, however, has the disadvantage of a reduced bonding strength between the liner and the corrugated flute of the corrugated cardboard, such that the material may delaminate.

In WO 99/29503 a cardboard material, in the form of a corrugated cardboard or laminated fibreboard, is disclosed. The material incorporates a buried shielding layer, which thus is protected from wear and particle rub off and which contains uniformly dispersed carbon black particles (Carbon Black). The shielding layer is enclosed on both sides by electrostatic dissipative liner layers with non-carbonaceous particles and with the dissipative properties obtained by means of other pigments. Owing to this, the material of the packaging unit is expensive and has the additional disadvantage that the conductive layer is not an exterior layer, which reduces the shielding effect.

EP-A-0508044 discloses a container for protecting electronic components. The container is advantageous in that the exterior surface is electrically conductive and the interior surface is electrostatic dissipative. The exterior conductive surface provides electrostatic shielding by means of a coating containing graphite or carbon black particles, said coating having a surface resistance which is less than 10⁴ Ω. The electrostatic dissipative interior surface has a non-carbonaceous coating with a surface resistance exceeding 10⁵ Ω. The container as disclosed has a surface resistance of the exterior surface which is considerably lower than the surface resistance of the interior surface, thus providing the basic discharge path for the electrostatic charges along the exterior surface. However, the container as disclosed, having a concentration of conductive carbon black particles on the container surface, is extremely exposed to wear and rub off of conductive particles.

### Basic idea of the invention

The object of the present invention is to provide a packaging unit of cardboard, which adequately protects products, such as sensitive electronic components, against electrostatic discharge and electrostatic fields and may endure a certain wear without a potential of particle sloughing or rub off that would damage the sensitive electronic components in the packaging unit. A further object of the invention is to provide a packaging unit which can be manufactured economically and which is made of a biodegradable material complying with the present environmental requirements on paper manufacturing, especially in respect of the requirements for using recycled paper in the production.

This object is achieved in accordance with the invention in a packaging unit, in a paper incorporated in a packaging unit and in a method for producing a paper, having the characterising features as defined in the appended claims.

### Short description of the drawings

The invention will be described more in detail below with reference to the appended drawings, in which
Figure 1 shows a cross-sectional view of a cardboard material for a packaging unit in accordance with one embodiment of the invention,
Figure 2 shows schematically one example of a paper manufacturing process in accordance with the invention, and
Figure 3 shows one example of a packaging unit in accordance with the invention which is made of the cardboard material as shown in Fig. 1.

### Detailed description of preferred embodiments of the invention

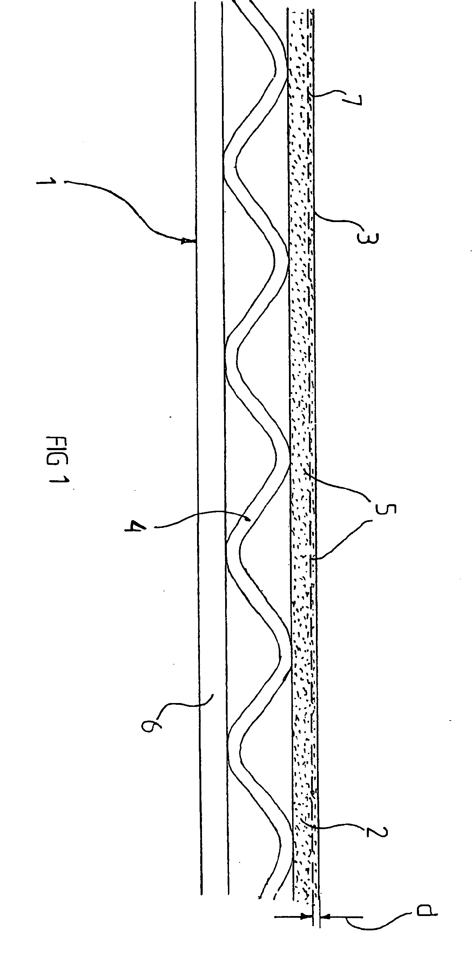

Figure 1 shows one example of a cardboard material 1, which in a punched and erected state is forming a packaging unit in accordance with the invention. In the embodiment as shown, the cardboard material 1 is a single fluted corrugated cardboard. The cardboard material may, however, within the scope of the invention, be a corrugated cardboard of a different type or a laminated cardboard with several mutually adhered layers of paper.

The cardboard material 1 in accordance with the invention is made up of an outer, homogeneous black paper 2 having conductive properties, an inner paper layer 6 having electrostatic dissipative properties and one or several intermediate paper layers 4. The outer paper liner 2 contains uniformly dispersed electrically conductive particles 5, preferably black or carbon particles (Carbon Black), imparting the electrically conductive properties to the paper. In this context, the term " conductive " has reference to a material having a resistance within the range of 1x10⁵ - 1x10¹² Ω and the term "electrostatic dissipative" has reference to a material having a resistance within the range of 1 x 106 - 1 x 10¹² Ω. The surface resistance of the outer paper liner 2 is, however, lower than the surface resistance of the inner dissipative paper liner 6 within the above ranges.

In the embodiment of the cardboard material as shown, the intermediate paper layer 4 is formed as a corrugated single flute, which in a conventional manner is joined to the surrounding liners 2, 6. The intermediate paper layer 4 is adapted to isolate the outer conductive liner 2 from the inner dissipative liner 6 and may preferably be made of an ordinary unbleached paper with no conductive properties. The inner dissipative liner 6, which does not form part of the present invention, preferably consists of a paper material having dissipative properties and which may resist wear and mechanical abrasion by means of a surface coating. The dissipative properties in the paper 6 may be accomplished by means of certain fillers, such as for example titanium dioxide (white colorant) or additives made of different forms of salts, phosphates or polymers.

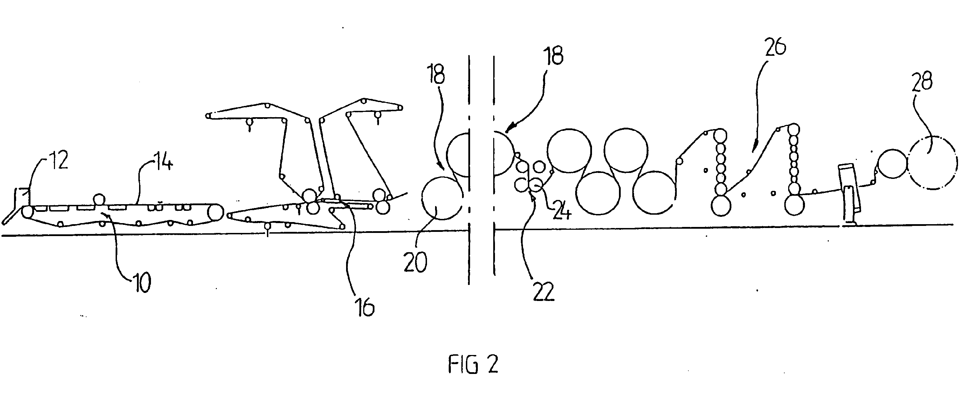

The outer conductive paper 2 consists of a homogeneous black and electrically conductive paper layer having specific properties, said paper being denominated "black paper" below. The paper may be produced in a manufacturing process, which is exemplified more in detail with reference to Fig. 2. The specific properties and composition of the paper are described more in detail in connection with the description of the manufacturing process below.

Black paper, according to the above, is preferably produced in a Fourdrinier paper machine which may be furnished with one or several endless wires, in the embodiment as shown in Fig. 2, one endless wire 10. A Fourdrinier paper machine having one single wire produces a single layered paper. It will be understood that the produced paper may, however, within the scope of the invention, as well comprise several layers and will thus be produced in a Fourdrinier paper machine with several, e.g. two, endless wires.

The pulp mixture or beating material to be fed into the paper machine is a pulp which is produced in accordance with the sulphate method. Said pulp consists for example of 20% short fibres and 80% long fibres, possibly mixed with internal waste. In accordance with the invention, the pulp may be exposed to an electrotechnical purification process in order to refine the pulp from conductive particles. As a result, a completely "pure" pulp in respect of conductive particles is achieved.

The pulp is fed from a breaker, through a chest and tube system (not shown) to the machine chest, in which the fibres are mechanically machined to roughen the surfaces and to bind the fibres together in order to obtain the beating degree required for the specific paper properties. The beating degree of the pulp is adapted such that the produced paper obtains the requisite quality as well as sufficient depth of penetration, as will be described more in detail below.

Preferably, the pulp mixture is subjected to an additional purification process prior to or possibly after additional additives are added to the pulp mixture. The purification process refine the pulp from particles, also conductive particles, which may have been added to the pulp during the beating of the fibres.

The required electrically conductive properties of the black paper are obtained by adding black or carbon particles 5, preferably such as acetylene black (Carbon Black), to the pulp. The black or carbon particles are added into the machine chest (not shown), which is the last chest ahead of the inlet box 12 in the paper manufacturing machine, in order to give the black particles sufficient dwell time with the paper fibres. As an end product, a paper, having a controlled predetermined conductivity and thus a controlled predetermined surface resistance, is obtained by means of adding a controlled predetermined amount of black or carbon particles 5 to the pulp, which previously has been refined from other conductive particles as described above.

A fixing agent is added to the pulp flow in the machine beater (not shown) for the purpose of fixing the black or carbon particles to the paper fibres. The fixing agent is cationic, i.e. it is active on the fibre surface which is negative, such that the black particles are bonded to the fibre surface.

Further, a hydrophobation agent is added following the machine chest pump (not shown). The hydrophobation agent is added primarily to reduce the hygroscopicity (Cobb-value) of the paper However, the hydrophobation agent has also a second important function in connection with the sealing of the black or carbon particles 5 to the paper, as will be described further below.

Just before the beating material is being fed into the paper manufacturing machine, a retention agent is added in order to optimise the retention of the black or carbon particles to the endless wire 14, i.e. to optimise the amount of fibres and/or chemicals remaining in the paper on the endless wire.

From the inlet box 12 in the paper manufacturing machine, the beating material initially is sprayed on to the wire 14, which is made of a plastic screen cloth. The water in the beating material is screened off on the wire, thus increasing the dryness from 0,25% to about 20,0%.

Subsequently, the paper is being fed to the press section 16, in which more water is removed. The dryness is thus increased to about 40,0%.

In the following drier section 18, the paper is dried when it passes through the steam-heated drying cylinders 20, thus obtaining a dryness of about 90% before it reaches the size press 22. As shown in Figure 2, the size press 22 is located comparatively far forward in the paper manufacturing machine and the manufacturing process. The location of the size press 22 is adapted to the transfer time of the paper between the formation of the paper at the inlet box 12 to the size press 22, such that the hydrophobation agent has obtained a certain degree or level of hardness when the paper reaches the size press, as will be described further below. Also the temperature in the steam-heated drying cylinders 20 affects the hardening process of the hydrophobation agent.

In the size press 22, chemicals and water are added and the moisture content is once again increased. The important sealing of the black or carbon particles 5 to the paper also takes place in the size press. The sealing is essential in order to prevent black or carbon particles from sloughing off from the paper when the exterior of the packaging unit is exposed to abrasion and wear, which would cause short-circuit in the sensitive electronic components. The uniformly dispersed black or carbon particles 5 may be sealed on one or on both surfaces of the paper and the sealing may be accomplished by adding a specific sealing agent, a size press substance 7, such as for example a water soluble polymer, a PVA-adhesive (polyvinyl alcohol), a PVAC (polyvinyl acetate), etc. In the size press 22, this substance 7 is being pressed against the paper between two rollers 24, which preferably may be rubber-covered.

The hydrophobation agent, which has previously been added in the process, consists of a hardenable agent, the hardening process of which has not yet been finalised in the stage of the process where the paper reaches the size press 22, as described above. The hardening process in progress of the hydrofobation agent in the paper in the size press 22 implies that the size press substance 7 not only is applied on the surface 3 of the paper, but also penetrates a section d into the paper, thus sealing the black particles 5 on the surface 3 as well as in the section d (see Figure 1) in the paper. The advantageous penetrating effect is accomplished through an interaction between the size press substance 7, the hydrofobation agent and the beating degree of the pulp. The beating degree, which affects the quality of the paper such that a low degree of beating implies a more porous paper and thus a lower quality, also affects the penetration capacity such that a high degree of beating generally implies a lower penetration capacity. In order to accomplish a specific predetermined penetration capacity and thus a specific penetration depth d, a lower degree of beating may be compensated by adding a larger quantity of the hydrophobation agent, which is disadvantageous in that the costs are higher. The beating degree may be measured as the air permeability through the paper and is defined in the unit seconds Gurley. A higher degree of beating thus gives a higher Gurley-value.

In the manufacturing process according to the invention, the quantity of added hydrofobation agent in the size press and the beating degree of the pulp are thus correlated in order to accomplish a predetermined sealing level of the size press substance 7 for the uniformly dispersed black or carbon particles 5 in the paper 2. Thus, the black or carbon particles 5 which are located in the section of the paper that may be exposed to wear and abrasion may be sealed in the paper, as described above. Besides a penetration d into the paper, the size press substance 7, which may consist of a water soluble polymer, covers the surface 3 of the black paper with such a thin coating that the conductivity of the paper 2 is not materially affected.

Following the size press 22, the size-pressed paper is being fed in the forward direction to the calender stacks 26, where the paper gets its final finish and is subsequently rolled up on Jumbo rolls 28.

In a preferred embodiment of the invention, a black paper is produced from a paper pulp having a beating degree within a range of 200 - 600 seconds Gurley, and preferably about 530 seconds Gurley. In addition, the hydrofobation agent Aquapel® 248, marketed by Hercules AB, Sweden, is added in a quantity that gives a Cobb-value of 25 - 35 g/m², corresponding to a quantity of hydrofobation agent of about 9,4 kg/ton produced paper. The speed of the paper web is within the range of 50 - 100 m/min, the speed in the preferred embodiment being about 70 m/min. The transfer time for the paper between the inlet box to the size press is about 1 minute and the length of the paper between these parts is about 70 - 80 m. In the preferred embodiment, the size press substance is a water soluble polyvinyl alcohol, Mowiol® 10-98, marketed by Clariant Sverige AB, Sweden and is supplied to the size press in a water solution of about 4% - 8%. Under given conditions, the penetration depth d of the size press substance is up to 1/3 of the thickness of the paper.

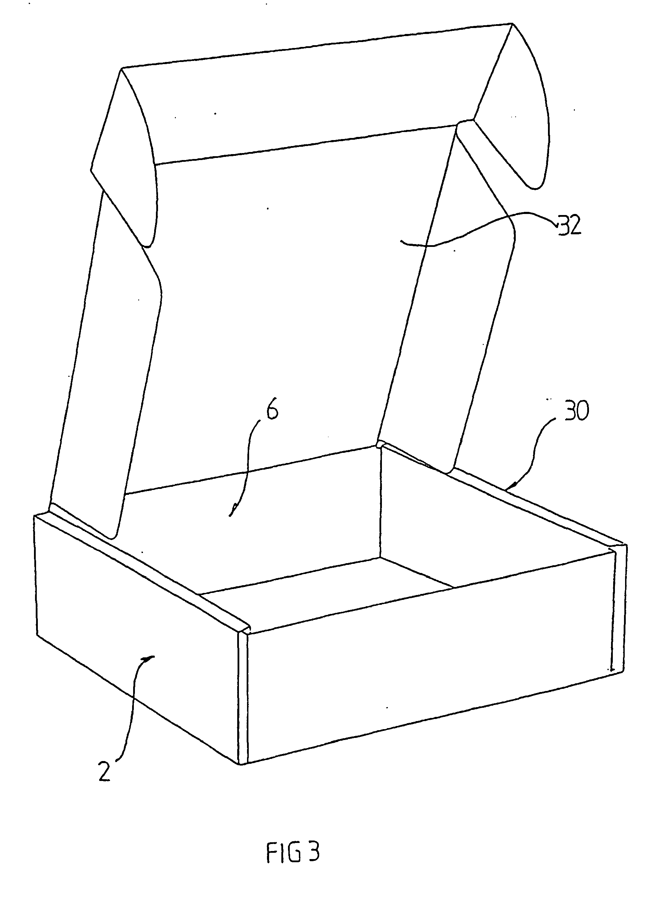

As described above, the black paper which is produced in the Fourdrinier paper machine, forms the outer layer of a cardboard material 1, which is punched to a cardboard blank and is erected to form a packaging unit especially designed to protect ESD-sensitive components, i.e. components sensitive to electrostatic discharge (ESD - electrostatic discharge). The cardboard material of Fig. 1 is punched to form foldable packaging unit blanks, which are erected to form a completed packaging unit, e.g. as shown in Fig. 3. The ESD-protected packaging unit 30 is openable by means of the lid 32. In the closed condition, however, the packaging unit entirely encloses the ESD-sensitive component with a uniform conductive exterior layer 2 and an interior, electrostatic dissipative layer 6, which is isolated from the exterior layer. The conductive paper layer 2 shields against electric fields and by means of the exterior position, static electricity is discharged in handling and unpacking of the packaging unit. Due to the efficient sealing of the black or carbon particles 5, as described above, the packaging unit will not exhibit any conductive particles rub off or sloughing which would cause short-circuit of the sensitive components.

In standardised testing of the inventive packaging unit according to SP-method 2473 (SP, Swedish National Testing and Research Institute), the surface resistance of the black conductive exterior of the packaging unit has been measured to values within the range of 5,2 x 10⁵ - 6,6 x 10¹⁰ Ω, while the surface resistance of the electrostatic dissipative interior of the packaging unit has been measured to 1,0 x 10¹¹ - 1,2 x 10¹¹ Ω. In addition, the discharge time from 1000 V to 100 V on the inside of the packaging unit was measured according to SP method 1074 with a result of a time less than 300 ms. Also the electrostatic shielding of an inventive packaging unit was measured according to SP method 1076. A value below 5 V was obtained with a discharge pulse of 1000 V, said value easily being below the upper limit value of 50 V. The packaging unit according to the invention thus fulfils the requirements under Class A (SP) in respect of the surface resistance and time of discharge and under Class C (SP) in respect of the shielding properties.

The paper according to the invention and also the composite packaging unit material may be recycled and become recovery pulp in new paper, thus meeting the requirements of the waste paper regulations. The packaging unit according to the invention comprises no dissolvents, toxic chemicals, such as copper, lead or other heavy alloys, which are common in this type of packaging units, or other substances that may disrupt or ruin the biodegradation which is important in a water cleaning process. The colouring pigments that are used in the packaging unit according to the invention may be separated through a settling and separating process .

## Claims

1. A packaging unit, particularly a packaging unit for protecting electronic components against electrostatic discharge, said packaging unit being formed of a cardboard material made of several layers of paper, incorporating an outer paper layer (2) forming the exterior of the packaging unit and having conductive properties and an inner paper layer (6) forming the interior of the packaging unit and having electrostatic dissipative properties, **charaeterised** in that said paper layer (2) forming the exterior of the packaging unit contains particles (5) which are conductive and are uniformly dispersed in the paper layer (2), and that said uniformly dispersed conductive particles are sealed or bound in the paper by means of a sealing agent (7) on the surface of the cardboard material forming the exterior surface of the packaging unit and in a section (d) of the paper layer (2) extending into the paper from said surface.

2. A packaging unit according to claim 1, **characterised in that** the cardboard material incorporates at least one additional paper layer (4) disposed between said outer paper layer (2) and said inner paper layer (6), such that the outer conductive paper layer (2) is separated from the inner electrostatic dissipative paper layer (6).

3. A packaging unit according to claim 2, **characterised in that** said additional paper layer (4) is forming a fluted corrugated layer in a corrugated cardboard and that said outer paper layer (2) and said inner paper layer (6) are forming liner layers being adhered to each side of the fluted corrugated layer.

4. A packaging unit according to any of the preceding claims, **characterised in that** the outer paper layer (2) is black and contains a uniform mixture of black or carbon particles (5).

5. A packaging unit according to any of the preceding claims, **characterised in that** the surface resistance of the outer conductive paper layer (2) is lower than the surface resistance of the inner electrostatic dissipative paper layer (6).

6. A packaging unit according to claim 5, **characterised in that** the outer conductive paper layer (2) has a surface resistance within the range 1 x 10⁵ - 1 x 10¹² Ω, preferably within the range 5 x 10⁵ - 10 x 10¹⁰Ω.

7. A packaging unit according to claim 5 or 6, **characterised in that** the inner electrostatic dissipative paper layer (6) has a surface resistance within the range 1 x 10⁶ - 1 x 10¹² Ω, preferably within the range 10 x 10¹⁰ - 1 x 10¹² Ω.

8. A packaging unit according to any of claims 1-7, **characterised in that** said section (d) extends up to 1/3 of the thickness of the paper layer (2).

9. A packaging unit according to any of the preceding claims, **characterised in that** the outer paper layer (2) contains a controlled predetermined amount of conductive particles (5).

10. A paper incorporated as a paper layer in a cardboard material for a packaging unit, particularly a packaging unit for protecting electronic components against electrostatic discharge, said cardboard material being made of several paper layers, **characterised in that** the paper contains particles (5), which are conductive and uniformly dispersed in the paper (2) and that the uniformly dispersed conductive particles are sealed or bound in the paper by means of a sealing agent (7) on one surface (3) of the paper and in a section (d) of the paper extending into the paper from said one surface (3).

11. A paper according to claim 10, **characterised in that** the paper contains a controlled predetermined amount of electrically conductive particles (5).

12. A paper according to any of claims 10 or 11, **characterised in that** the paper contains a hardenable hydrophobation agent which is interacting with said sealing agent (7) for the penetration of said section (d).

13. A paper according to claim 12, **characterised in that** the paper is produced from a paper pulp having a beating degree which is correlated to the quantity of hydrophobation agent added to the pulp, said interacting beating degree and quantity of hydrophobation agent control the depth of penetration (d) of the sealing agent (7) into the paper (2).

14. A paper according to claim 13, **characterised in that** the hydrophobation agent is added in a quantity that gives a Cobb-value of 25 - 35 g/m² and that the beating degree is within the range 200 - 600 seconds Gurley, preferably about 530 seconds Gurley.

15. A paper according to claim 14, **characterised in that** the sealing agent (7) is a polyvinyl alcohol mixed with water to about 4% - 8%.

16. A method for producing a paper from a paper pulp in a paper manufacturing machine for use as one of several paper layers in a cardboard material for a packaging unit, particularly a packaging unit for protecting electronic components against electrostatic discharge, **characterised by** the steps of adding a substance containing electrically conductive particles (5) and a hardenable hydrophobation agent to the paper pulp prior to the pulp being fed into the paper manufacturing machine, adding a sealing agent (7) to the paper web in a press (22) in the paper manufacturing machine at a stage when the hardening process of the hydrophobation agent has not yet been finalised and pressing the sealing agent (7) by the press (22) on the surface (3) of the paper and into the paper from said surface (3) by means of interaction with the hydrophobation agent, the hardening process of which not being finalised, in order to seal or bind the conductive particles (5) on said surface (3) and in a section (d) extending from said surface (3) into the paper.

17. A method according to claim 16, **characterised by** beating the paper pulp to a predetermined beating degree, adding a predetermined quantity of hydrophobation agent to the pulp, said quantity being correlated to said beating degree such that the penetration depth (d) for the sealing agent is controlled by the interaction of the beating degree and the hydrofobation agent

18. A method according to any of claims 16 or 17, **characterised by** refining the paper pulp from electrically conductive particles, and subsequently adding a controlled predetermined amount of electrically conductive particles to the pulp prior to being fed into the paper manufacturing machine.

19. A method according to claim 17, **characterised by** beating the paper pulp to a beating degree in the range 200 - 600 seconds Gurley and adding a quantity of the hydrophobation agent resulting in a Cobb-value of 25 - 35 g/m².

20. A method according to claim 19, **characterised by** a running time for the paper between an inlet box (12) at the inlet of the paper manufacturing machine and said press (22) of about 1 minute.

## Patentansprüche

1. Verpackungseinheit, insbesondere eine Verpackungseinheit zum Schutz von elektronischen Bauteilen gegen elektrostatische Entladung, welche Verpackungseinheit aus einem Pappematerial gebildet ist, das aus mehreren Papierschichten hergestellt ist, die eine äußere Papierschicht (2), die die Außenseite der Verpackungseinheit bildet und Leitfähigkeitseigenschaften aufweist, und eine innere Papierschicht (6) enthalten, die die Innenseite der Verpackungseinheit bildet und elektrostatische Elektrizität ableitende Eigenschaften hat, **dadurch gekennzeichnet, dass** die Papierschicht (2), die die Außenseite der Verpackungseinheit bildet, Teilchen (5) enthält, die leitfähig sind und in der Papierschicht (2) gleichmäßig verteilt sind, und dass die gleichmäßig verteilten leitfähigen Teilchen in dem Papier mit einem Versiegelungsmittel (7) auf der Oberfläche des Pappematerials, das die äußere Oberfläche der Verpackungseinheit bildet, und in einem Abschnitt (d) der Papierschicht (2), der sich von der Oberfläche in das Papier hinein erstreckt, versiegelt oder gebunden sind.

2. Verpackungseinheit nach Anspruch 1, **dadurch gekennzeichnet, dass** das Pappematerial mindestens eine zusätzliche Papierschicht (4) enthält, die zwischen der äußeren Papierschicht (2) und der inneren Papierschicht (6) angeordnet ist, sodass die äußere leitfähige Papierschicht (2) von der inneren, elektrostatische Elektrizität ableitenden Papierschicht (6) getrennt ist.

3. Verpackungseinheit nach Anspruch 2, **dadurch gekennzeichnet, dass** die zusätzliche Papierschicht (4) eine gerippte, gewellte Schicht in einer Wellpappe bildet und dass die äußere Papierschicht (2) und die innere Papierschicht (6) Deckenschichten bilden, die mit den beiden Seiten der gerippten, gewellten Schicht verklebt sind.

4. Verpackungseinheit nach einem der vorstehenden Ansprüche, **dadurch gekennzeichnet, dass** die äußere Papierschicht (2) schwarz ist und eine gleichförmige Mischung aus Schwarz- oder Kohlenstoffteilchen (5) enthält.

5. Verpackungseinheit nach einem der vorstehenden Ansprüche, **dadurch gekennzeichnet, dass** der Oberflächenwiderstand der äußeren leitfähigen Papierschicht (2) niedriger ist als der Oberflächenwiderstand der inneren, elektrostatische Elektrizität ableitenden Papierschicht (6).

6. Verpackungseinheit nach Anspruch 5, **dadurch gekennzeichnet, dass** die äußere leitfähige Papierschicht (2) einen Oberflächenwiderstand innerhalb des Bereichs 1 x 10⁵ - 1 x 10¹² Ω, vorzugsweise innerhalb des Bereichs 5 x 10⁵ - 10 x 10¹⁰ Ω hat.

7. Verpackungseinheit nach Anspruch 5 oder 6, **dadurch gekennzeichnet, dass** die innere, elektrostatische Elektrizität ableitende Papierschicht (6) einen Oberflächenwiderstand innerhalb des Bereichs 1 x 10⁶ - 1 x 10^{1z} Ω, vorzugsweise innerhalb des Bereichs 10 x 10¹⁰- 1 x 10¹² Ω hat.

8. Verpackungseinheit nach einem der Ansprüche 1 bis 7, **dadurch gekennzeichnet, dass** der Abschnitt (d) sich bis zu 1/3 der Dicke der Papierschicht (2) erstreckt.

9. Verpackungseinheit nach einem der vorstehenden Ansprüche, **dadurch gekennzeichnet, dass** die äußere Papierschicht (2) eine kontrollierte vorbestimmte Menge der leitfähigen Teilchen (5) enthält.

10. Papier, das als Papierschicht in ein Pappematerial für eine Verpackungseinheit eingebaut ist, insbesondere eine Verpackungseinheit zum Schutz von elektronischen Bauteilen gegen elektrostatische Entladung, welches Pappematerial aus mehreren Papierschichten aufgebaut ist, **dadurch gekennzeichnet, dass** das Papier Teilchen (5) enthält, die leitfähig sind und in dem Papier (2) gleichmäßig verteilt sind, und dass die gleichmäßig verteilten leitfähigen Teilchen in dem Papier mittels eines Versiegelungsmittels (7) auf einer Oberfläche (3) des Papiers und in einem Abschnitt (d) des Papiers, der sich von der Oberfläche (3) in das Papier erstreckt, versiegelt oder gebunden sind.

11. Papier nach Anspruch 10, **dadurch gekennzeichnet, dass** das Papier eine kontrollierte vorbestimmte Menge von elektrisch leitfähigen Teilchen (5) enthält.

12. Papier nach einem der Ansprüche 10 oder 11, **dadurch gekennzeichnet, dass** das Papier ein härtbares Hydrophobierungsmittel enthält, das mit dem Versiegelungsmittel (7) zur Durchdringung des Abschnitts (d) zusammenwirkt.

13. Papier nach Anspruch 12, **dadurch gekennzeichnet, dass** das Papier aus einem Papierbrei hergestellt wird, der einen Mahlgrad hat, der mit der Menge des zu dem Papierbrei zugesetzten Hydrophobierungsmittels in Beziehung gesetzt wird, wobei die Wechselwirkung zwischen dem Mahlgrad und der Menge des Hydrophobierungsmittels die Eindringtiefe (d) des Versiegelungsmittels (7) in das Papier (2) steuert.

14. Papier nach Anspruch 13, **dadurch gekennzeichnet, dass** das Hydrophobierungsmittel in einer Menge zugesetzt wird, die einen Cobb-Wert von 25-35 g/m² ergibt, und dass der Mahlgrad innerhalb des Bereichs 200-600 Sekunden Gurley, vorzugsweise etwa 530 Sekunden Gurley liegt.

15. Papier nach Anspruch 14, **dadurch gekennzeichnet, dass** das Versiegelungsmittel (7) ein Polyvinylalkohol ist, der zu etwa 4% bis 8% mit Wasser gemischt ist.

16. Verfahren zur Herstellung eines Papiers aus einem Papierbrei in einer Papierherstellungsmaschine zur Verwendung als eine von mehreren Papierschichten in einem Pappematerial für eine Verpackungseinheit, insbesondere eine Verpackungseinheit zum Schutz von elektronischen Bauteilen gegen elektrostatische Entladung, **gekennzeichnet durch** die Schritte: Zugeben eines elektrisch leitfähige Teilchen (5) und ein härtbares Hydrophobierungsmittel enthaltenden Stoffes zu dem Papierbrei, bevor der Papierbrei in die Papierherstellungsmaschine geliefert wird, Zugeben eines Versiegelungsmittels (7) zu der Papierbahn in einer Presse (22) in der Papierherstellungsmaschine in einem Zustand, in dem der Härtungsprozess des Hydrophobierungsmittels noch nicht beendet ist, und Pressen des Versiegelungsmittels (7) **durch** die Presse (22) auf die Oberfläche (3) des Papiers und von der Oberfläche (3) in das Papier mittels der Wechselwirkung zwischen dem Hydrophobierungsmittel, dessen Härtungsprozess noch nicht beendet ist, um die leitfähigen Teilchen (5) auf der Oberfläche (3) und in einem Abschnitt (d), der sich von der Oberfläche (3) in das Papier erstreckt, zu versiegeln oder zu binden.

17. Verfahren nach Anspruch 16, **dadurch gekennzeichnet, dass** der Papierbrei auf einen vorbestimmten Mahlgrad gemahlen wird, eine vorbestimmte Menge Hydrophobierungsmittel zu dem Brei zugegeben wird, wobei die Menge mit dem Mahlgrad in der Weise in Beziehung gesetzt ist, dass die Eindringtiefe (d) des Versiegelungsmittels durch die Wechselwirkung des Mahlgrades und des Hydrophobierungsmittels gesteuert wird.

18. Verfahren nach einem der Ansprüche 16 oder 17, **gekennzeichnet durch** das Raffinieren des Papierbreis von elektrisch leitfähigen Teilchen und das anschließende Zugeben einer kontrollierten vorbestimmten Menge von elektrisch leitfähigen Teilchen zu dem Papierbrei, bevor er in die Papierherstellungsmaschine geliefert wird.

19. Verfahren nach Anspruch 17, **gekennzeichnet durch** das Mahlen des Papierbreis auf einen Mahlgrad im Bereich von 200-600 Sekunden Gurley und Zugeben einer Menge des Hydrophobierungsmittels, die in einem Cobb-Wert von 25-35 g/m² resultiert.

20. Verfahren nach Anspruch 19, **gekennzeichnet durch** eine Laufzeit für das Papier zwischen einem Eingangskasten (12) am Eingang der Papierherstellungsmaschine und der Presse (22) von etwa 1 Minute.

## Revendications

1. Emballage, particulièrement un emballage pour protéger des composants électroniques contre une décharge électrostatique, ledit emballage étant formé d'un matériau de carton constitué de plusieurs couches de papier, incorporant une couche extérieure (2) de papier formant l'extérieur de l'emballage et ayant des propriétés conductrices et une couche intérieure (6) de papier formant l'intérieur de l'emballage et ayant des propriétés de dissipation électrostatique, **caractérisé en ce que** ladite couche (2) de papier formant l'extérieur de l'emballage contient des particules (5) qui sont conductrices et qui sont dispersées uniformément dans la couche (2) de papier, et **en ce que** lesdites particules conductrices dispersées uniformément sont scellées ou liées au papier au moyen.d'un agent (7) de scellement sur la surface du matériau de carton formant la surface extérieure de l'emballage et dans une section (d) de la couche (2) de papier qui s'étend dans le papier à partir de ladite surface.

2. Emballage selon la revendication 1, **caractérisé en ce que** le matériau de carton incorpore au moins une couche supplémentaire (4) de papier disposée entre ladite couche extérieure (2) de papier et ladite couche intérieure (6) de papier, de sorte que la couche extérieure conductrice (2) de papier est séparée de la couche intérieure de dissipation électrostatique (6) de papier.

3. Emballage selon la revendication 2, **caractérisé en ce que** ladite couche supplémentaire (4) de papier forme une couche cannelée ondulée d'un carton ondulé, et **en ce que** ladite couche extérieure (2) de papier et ladite couche intérieure (6) de papier forment des couches de garniture collées de chaque côté de la couche cannelée ondulée.

4. Emballage selon l'une quelconque des revendications précédentes, **caractérisé en ce que** la couche extérieure (2) de papier est noire et contient un mélange uniforme de particules (5) noires ou de particules de carbone.

5. Emballage selon l'une quelconque des revendications précédentes, **caractérisé en ce que** la résistance superficielle de la couche extérieure conductrice (2) de papier est inférieure à la résistance superficielle de la couche intérieure de dissipation électrostatique (6) de papier.

6. Emballage selon la revendication 5, **caractérisé en ce que** la couche extérieure conductrice (2) de papier a une résistance superficielle comprise dans la plage de 1 x 10⁵ à 1 x 10¹² Ω, de préférence dans la plage de 5 x 10⁵ à 10 x 10¹⁰ Ω.

7. Emballage selon la revendication 5 ou 6, **caractérisé en ce que** la couche intérieure de dissipation électrostatique (6) de papier a une résistance superficielle comprise dans la plage de 1 x 10⁶ à 1 x 10¹² Ω, de préférence dans la plage de 10 x 10¹⁰ à 1 x 10¹² Ω.

8. Emballage selon l'une quelconque des revendications 1 à 7, **caractérisé en ce que** ladite section (d) s'étend jusqu'à 1/3 de l'épaisseur de la couche (2) de papier.

9. Emballage selon l'une quelconque des revendications précédentes, **caractérisé en ce que** la couche extérieure (2) de papier contient une quantité prédéterminée commandée de particules conductrices (5).

10. Papier incorporé en tant que couche de papier dans un matériau de carton d'un emballage, particulièrement d'un emballage destiné à protéger des composants électroniques contre une décharge électrostatique, ledit matériau de carton étant constitué de plusieurs couches de papier, **caractérisé en ce que** le papier contient des particules (5), qui sont conductrices et dispersées uniformément dans le papier (2), et **en ce que** les particules conductrices dispersées uniformément sont scellées ou liées au papier au moyen d'un agent (7) de scellement sur une surface (3) du papier et dans une section (d) du papier, qui s'étend dans le papier à partir de ladite surface (3).

11. Papier selon la revendication 10, **caractérisé en ce que** le papier contient une quantité prédéterminée commandée de particules électriquement conductrices (5).

12. Papier selon l'une quelconque des revendications 10 ou 11, **caractérisé en ce que** le papier contient un agent pouvant durcir et donnant une caractéristique hydrophobe, qui interagit avec ledit agent (7) de scellement en ce qui concerne la pénétration de ladite section (d).

13. Papier selon la revendication 12, **caractérisé en ce que** le papier est produit à partir d'une pâte à papier ayant un degré de raffinage qui est en corrélation avec la quantité d'agent donnant une caractéristique hydrophobe ajouté à la pâte, ledit degré de raffinage et ladite quantité d'agent donnant une caractéristique hydrophobe qui interagissent commandent la profondeur de pénétration (d) de l'agent (7) de scellement dans le papier (2).

14. Papier selon la revendication 13, **caractérisé en ce que** l'agent donnant une caractéristique hydrophobe est ajouté en une quantité qui donne une valeur de Cobb de 25 à 35 g/m², et **en ce que** le degré de raffinage est compris dans la plage de 200 à 600 Gurley seconde, de préférence d'environ 530 Gurley seconde.

15. Papier selon la revendication 14, **caractérisé en ce que** l'agent (7) de scellement est un alcool polyvinylique mélangé avec de l'eau à un rapport d'environ 4 % à 8 %.

16. Procédé pour produire un papier à partir d'une pâte à papier dans une machine de fabrication de papier pour utilisation en tant que l'une de plusieurs couches de papier dans un matériau de carton d'un emballage, particulièrement un emballage destiné à protéger des composants électroniques contre une décharge électrostatique, **caractérisé par** les étapes dans lesquelles on ajoute une substance contenant des particules électriquement conductrices (5) et un agent pouvant durcir et donnant une caractéristique hydrophobe à la pâte à papier avant d'amener la pâte dans la machine de fabrication de papier, on ajoute un agent (7) de scellement à la bande de papier dans une presse (22) de la machine de fabrication de papier à un stade auquel le traitement de durcissement de l'agent donnant une caractéristique hydrophobe n'a pas encore été finalisé, et l'on presse l'agent (7) de scellement à l'aide de la presse (22) sur la surface (3) du papier et dans le papier à partir de ladite surface (3) au moyen d'une interaction avec l'agent donnant une caractéristique hydrophobe dont le traitement de durcissement n'est pas finalisé afin de sceller ou de lier les particules conductrices (5) à ladite surface (3) et dans une section (d) s'étendant à partir de ladite surface (3) dans le papier.

17. Procédé selon la revendication 16, **caractérisé par** le raffinage de la pâte à papier à un degré de raffinage prédéterminé, l'ajout d'une quantité prédéterminée d'agent donnant une caractéristique hydrophobe à la pâte, ladite quantité étant en corrélation avec ledit degré de raffinage de sorte que la profondeur (d) de pénétration de l'agent de scellement est commandée par l'interaction du degré de raffinage et de l'agent donnant une caractéristique hydrophobe.

18. Procédé selon l'une quelconque des revendications 16 ou 17, **caractérisé par** le raffinage de la pâte à papier à partir de particules électriquement conductrices, et l'ajout ultérieur d'une quantité prédéterminée commandée de particules électriquement conductrices à la pâte avant de l'amener dans la machine de fabrication de papier.

19. Procédé selon la revendication 17, **caractérisé par** le raffinage de la pâte à papier à un degré de raffinage compris dans la plage de 200 à 600 Gurley seconde et l'ajout d'une quantité de l'agent donnant une caractéristique hydrophobe ayant pour résultat une valeur de Cobb de 25 à 35 g/m².

20. Procédé selon la revendication 19, **caractérisé par** un temps de passage du papier entre une boîte (12) d'entrée située au niveau de l'entrée de la machine de fabrication de papier et ladite presse (22) d'environ 1 minute.
